# EUROPEAN PATENT APPLICATION

(11) **EP 2 312 592 A2**
(43) Date of publication of application: **20.04.2011**
(21) Application number: 09805181.6
(22) Date of filing: 04.08.2009
(51) Int. Cl.: H01B 12/00, H01B 13/00

(54) **MELTING DIFFUSION WELDING METHOD FOR SECOND GENERATION HIGH TEMPERATURE SUPERCONDUCTING WIRE**

(30) Priority: 04.08.2008 KR 20080076174; 04.08.2008 KR 20080076178
(71) Applicant: K. Joins, Seoul 136-701 (KR)
(72) Inventor: LEE, Haigun, Seoul 130-100 (KR); OH, Young Kun, Seoul 133-070 (KR)
(74) Representative: Finnie, Peter John
(86) International application number: PCT/KR2009/004360
(87) International publication number: WO 2010/016720

(57) **Abstract**

Provided is a method for joining two strands of second-generation high-temperature superconducting wire, each of which includes a substrate, a buffer layer, a superconducting layer and a stabilizer layer. The method comprises: partially removing each of the stabilizer layers to expose a portion of the superconducting layer; bringing the exposed portions of the superconducting layers into contact with each other and fixing the superconducting layers to each other; heating the strands of superconducting wire to the melting point of the superconducting layers to melt-diffuse the superconducting layers in contact with each other and to join the strands of superconducting wire together; and oxidizing the junction between the strands of superconducting wire in an oxygen atmosphere ('oxygenation annealing'). The oxygenation annealing restores the superconducting properties of the superconducting wires lost during the melting diffusion. According to the method, the superconducting layers are brought into direct contact with each other without any mediating material therebetween, followed by melting diffusion. Accordingly, the method enables the fabrication of sufficiently long superconducting wires without any substantial contact resistance, compared to non-superconducting joining. Particularly, the oxygen partial pressure is adjusted to a pressure close to a vacuum during the melting diffusion to lower the eutectic melting point of the superconductors, so that the superconducting wires can be joined together while protecting the constituent layers (e.g., the stabilizer layers containing silver (Ag)) from melting.

## Description

### [Technical Field]

One or more embodiments of the present invention relates to a method for joining second-generation high-temperature superconducting wires, each of 15 which includes a substrate, a buffer layer, a superconducting layer and a stabilizer layer. More specifically, one or more embodiments of the present invention relates to a method for joining two second-generation high temperature superconducting wires wherein a superconducting layer of one of the superconducting wires is brought into direct contact with and joined to a superconducting layer of the other superconducting wire, followed by melting diffusion under a controlled oxygen partial pressure to connect the superconducting wires to each other into a single strand.

Particularly, one or more embodiments of the present invention relates to a method for joining second-generation high-temperature superconducting wires under a controlled oxygen partial pressure wherein the superconducting wires are brought into contact with each other and joined together by melting diffusion at an oxygen partial pressure close to a vacuum, where the eutectic melting point of the superconductors is lowered.

One or more embodiments of the present invention also relates to a method for joining second-generation high-temperature superconducting wires wherein a stabilizer layer of each of the superconducting wires is etched to expose a portion of superconducting layer, the exposed portions of the superconducting layers are fixed in contact with each other by a holder, the fixed portions are joined together by melting diffusion, and the joined portions are oxidized ('oxygenation annealing').

### [background Art]

It is generally necessary to join superconducting wires together in the following cases: i) in the case where short superconducting wires are joined together to extend the whole length of the joined superconducting wires and be wound into a coil; ii) in the case where joining between superconducting magnet coils is required to connect coils of wound superconducting wires to each other; and iii) in the case where both ends of a terminal are connected to each other to establish a superconducting closed loop for the construction of a magnet system that is operated in a persistent current mode.

Particularly, superconducting wires should be connected to each other into a single wire in an applied superconducting system essentially requiring a persistent current mode operation so that the applied superconducting system can be operated without any loss after the superconducting wires are wound. This connection of superconducting wires is also applied to superconducting magnet systems, for example, Nuclear Magnetic Resonance (NMR), Magnetic Resonance Imaging (MRI) and Superconducting Magnet Energy Storage (SMES) systems, as well as applied superconducting systems.

A junction between two superconducting wires generally has lower characteristics than the other unjoined portions of the superconducting wires. Therefore, the critical current of the joined superconducting wires is strongly dependent on the characteristics of the junction when a superconducting system using the superconducting wires is operated in a persistent current mode. In conclusion, an improvement in the critical current properties of a junction between superconducting wires is very important in the construction of an applied superconducting system that is operated in a persistent current mode. Unlike low-temperature superconducting wires, high-temperature superconducting tape wires are very difficult to join together while maintaining their superconducting state because th'e superconductors are made of ceramic.

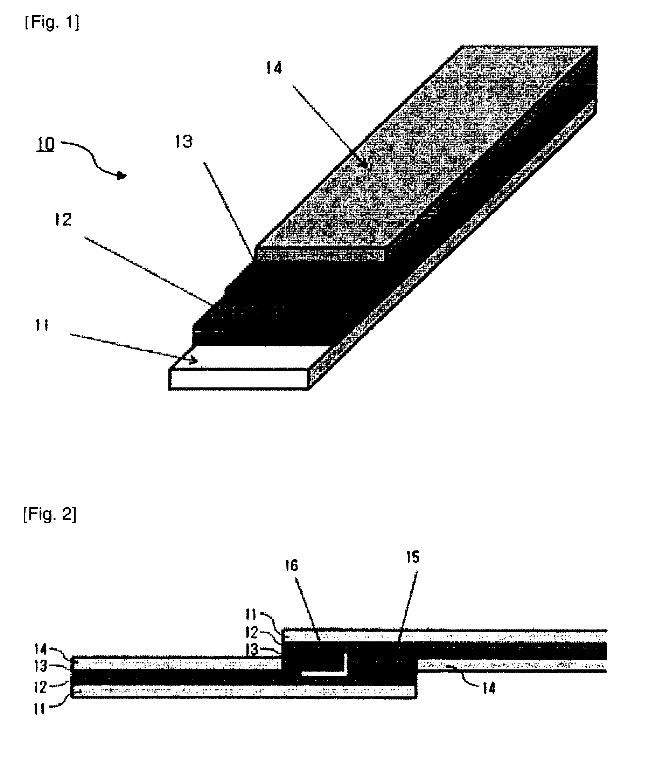

With reference to FIGS. 1 and 2, an explanation will be given of a conventional method for joining second-generation high-temperature superconducting wires.
FIG. 1 is a view illustrating the structure of a second-generation hightemperature superconducting wire (YBCO-coated conductor (CC)).
FIG. 2 is a cross-sectional view illustrating non-superconducting joining of general second-generation high-temperature superconducting wires (YBCO-CC) and showing a flow of electricity in the superconducting wires.

As illustrated in FIG. 1, the second-generation high-temperature superconducting wire 10 has a laminate structure and is in the shape of a tape. The superconducting wire 10 includes a substrate 11, a buffer layer 12, a superconducting layer 13 and a stabilizer layer 14 laminated in this order.

The substrate 11 is made of a metallic material such as nickel (Ni) or a nickel alloy. The metallic material is rolled and annealed so as to have a cube texture.

The buffer layer 12 is formed of a material, such as ZrO₂ CeO₂, YSZ, Y₂O₃ or HfO₂, and has a monolayer or multilayer structure. The buffer layer 12 is epitaxially stacked on the substrate 11.

The superconducting layer 13 is formed of an oxide superconducting material, typified by YBa₂Cu₃O_{7-X} in which the molar ratio of Y:Ba:Cu is 1:2:3 and the molar ratio (7-x) of oxygen (O) is typically in the range of 6.4 to 7. Since the characteristics of the superconducting layer 13 are strongly dependent on the oxygen content of the oxide superconductor constituting the superconducting layer 13, it is required to maintain the molar ratio of oxygen constant.

The stabilizer layer 14 is formed on top of the superconducting layer 13 to electrically stabilize the underlying superconducting layer 13. For example, the stabilizer layer 14 protects the superconducting layer 13 from overcurrent. The stabilizer layer 14 is formed of a metallic material having a relatively low electrical resistance to protect the superconducting wire when an overcurrent flows through the superconducting wire. For example, silver or copper may be used as the metallic material for the stabilizer layer 14. Stainless steel may also be used.

FIG. 2 illustrates a conventional joining method for the superconducting wire of FIG. 1 to another superconducting wire of the same type. As illustrated in FIG. 2, the stabilizer layers 14 formed on top of the superconducting layers 13 to be connected to each other are partially removed by etching to expose portions of the superconducting layers 13. The exposed portions of the superconducting layers 13 are joined together via a material (e.g., a solder 15) for a normal conducting layer. However, when an electric current 16 flows through the normal conducting layer, it is inevitable that contact resistance occurs across the joined portions.

When an electric current flows, heat is emitted by the contact resistance to raise the temperature of the junction between the superconducting wires. In the worst case, this temperature rise may cause a transition from the superconductors exhibiting superconducting properties at a low temperature to normal conductors. Even if the superconductors do not undergo a phase transition, cooling of the junction between the superconducting wires incurs considerable costs.

Above all, the use of a resistance joining technique such as soldering for the superconducting wires generates a resistance around the junction between the superconducting wires. In a strict sense, this resistance joining makes it impossible to operate a superconducting system using the superconducting wires in a persistent current mode.

Materials (YBCO materials such as Y123) of the second-generation high-temperature superconducting wires have a relatively high critical current when crystals grow with orientation. Thus, when it is intended to join the two strands of second-generation high-temperature superconducting wire together by bringing the strands of superconducting wire into direct contact with each other, heat treatment of the strands of superconducting wire from a high temperature to the melting point of the wire material would be needed to allow the strands of superconducting wire to have the same crystal orientation even at the junction between the superconducting wires. However, when the YBCO material is heat treated from a high temperature to its melting point, silver (Ag) present in YBCO-CC as the second-generation high-temperature superconducting wires may primarily be melted at the too high heat treatment temperature, which makes it impossible to heat treat the YBCO material.

A direct melt-textured process requires a high temperature to heat treat the junction between the two strands of second-generation high-temperature superconducting wire. At this time, since the junction between the 10 superconducting wires is heat treated as a whole, the high heat treatment temperature may increase the possibility of contamination or deformation of the constituent layers (e.g., the stabilizer layers 14) of the superconducting wires.

### [Disclosure]

### [Technical Problem]

It is an object of the present invention to provide a method for joining two strands of second-generation high-temperature superconducting wire, each of which includes a substrate, a buffer layer, a superconducting layer and a stabilizer layer, wherein the superconducting layers of the superconducting 20 wires are brought into direct contact with each other, followed by melting diffusion to connect the superconducting layers to each other into a single strand.

### [Technical Solution]

In order to accomplish the object of the present invention, there is provided a method for joining two strands of second-generation high-temperature superconducting wire, each of which includes a superconducting layer and a stabilizer layer, the method comprising (a) partially removing each of the stabilizer layers to expose a portion of the superconducting layer, (b) bringing the exposed portions of the superconducting layers into contact with each other and fixing the superconducting layers to each other, (c) heating the fixed portions of the superconducting layers to the melting point of the superconducting layers to melt-diffuse the superconducting layers in contact with each other and to join the strands of superconducting wire together, and (d) oxidizing the junction between the strands of superconducting wire in an oxygen atmosphere ('oxygenation annealing').

In step (c), the strands of superconducting wire are joined together under a controlled oxygen partial pressure where the melting point of the superconducting layers becomes lower than the melting point of the stabilizer layers.

Step (a) includes (a1) patterning each of the stabilizer layers using a resist to expose a portion of the stabilizer layer and (a2) removing the exposed portions of the stabilizer layers by etching.

In step (a), a region ranging from one distal end of each of the superconducting wires to a portion spaced a predetermined distance from the distal end of the superconducting wire is removed from the stabilizer layer. In step (b), one distal end of one of the strands of superconducting wire is in touch with a stepped portion of the other strand of superconducting wire and the superconducting layers are fixed in close contact with each other.

In an embodiment, in step (b), after the superconducting layers of the two strands of superconducting wire are brought into contact with each other, upper and lower metal plates and fastening means for fastening the metal plates are used to fix the superconducting layers to each other.

The metal plates and the fastening means are made of a material resistant to a temperature of at least 1,000 °C.

In an embodiment, step (d) is carried out by continuously circulating a flow of oxygen in a furnace at 450°C. to 650 °C.

Step (d) is carried out until the content of oxygen (0) atoms in the superconducting layers becomes 6.4 to 7 moles on the basis that yttrium (Y), barium (Ba) and copper (Cu) as constituent elements of the superconducting layers are 1, 2 and 3 moles, respectively.

### [Advantageous Effects]

As is apparent from the above description, according to the method of embodiments of the present invention, the superconducting layers are brought into direct contact with each other without any mediating material therebetween, followed by melting diffusion. Accordingly, the method according to embodiments of the present invention enables the fabrication of sufficiently long superconducting wires without any substantial contact resistance, compared to non-superconducting joining. In addition, according to the method of embodiments of the present invention, the oxygenation annealing in an oxygen atmosphere is performed after the high-temperature melting diffusion to compensate for oxygen lost from the superconducting layers during the melting diffusion, so that the superconducting properties of the superconductors can be maintained. Furthermore, according to the method of embodiments of the present invention, the oxygen partial pressure is adjusted to a pressure close to a vacuum to lower the eutectic melting point of the superconductors, so that the superconducting wires can be joined together while protecting the constituent layers (e.g., the silver (Ag)-containing stabilizer layers) from melting.

### [Description of Drawings]

FIG. 1 is a view illustrating the structure of a second-generation high-temperature superconducting wire (YBCO-CC);
FIG. 2 is a cross-sectional view illustrating a method for joining general second-generation high-temperature superconducting wires (YBCO-CC) using a normal conductor and showing a flow of electricity in the superconducting wires;

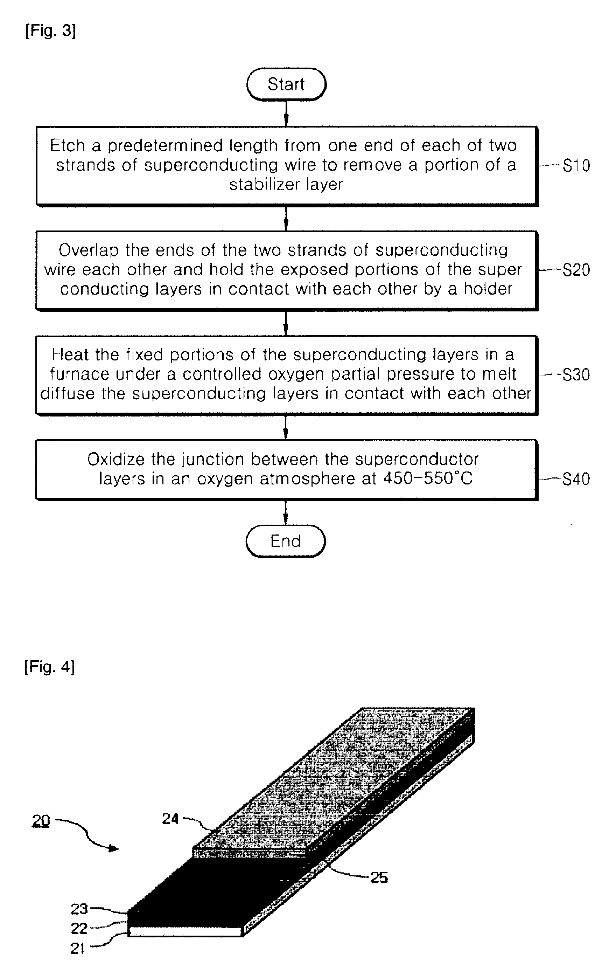

FIG. 3 is a flow chart for explaining a method for joining second- generation high-temperature superconducting wires by melting diffusion under a controlled oxygen partial pressure according to an embodiment of the present invention;
FIG. 4 is a view illustrating a second-generation high-temperature superconducting wire (YBCO-CC) after a portion of a stabilizer layer is removed from one end of the superconducting wire, in accordance with an embodiment of the present invention;

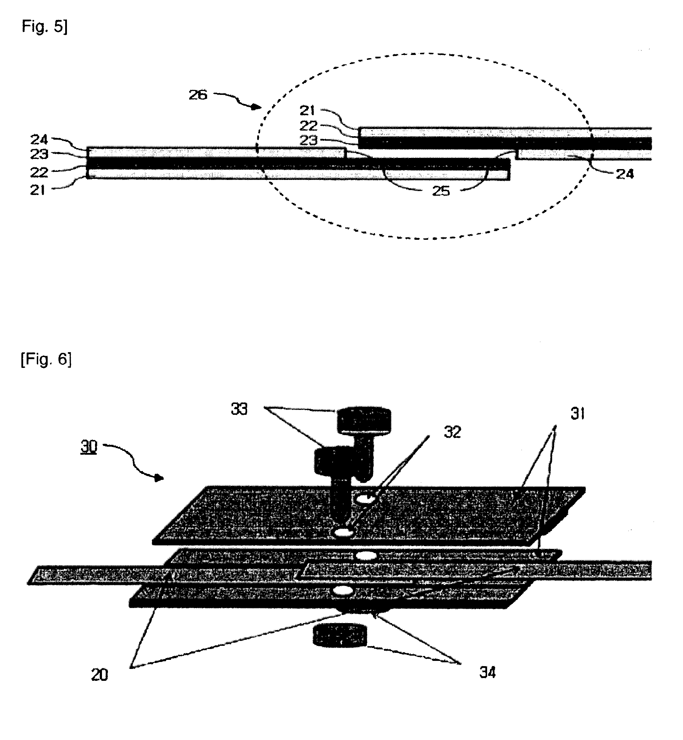

FIG. 5 is a view illustrating a state in which two strands of superconducting wire face and are brought into contact with each other in accordance with an embodiment of the present invention;
FIG. 6 is a view illustrating the constitution of a holder for holding two strands of superconducting wire in contact with each other in accordance with an embodiment of the present invention;

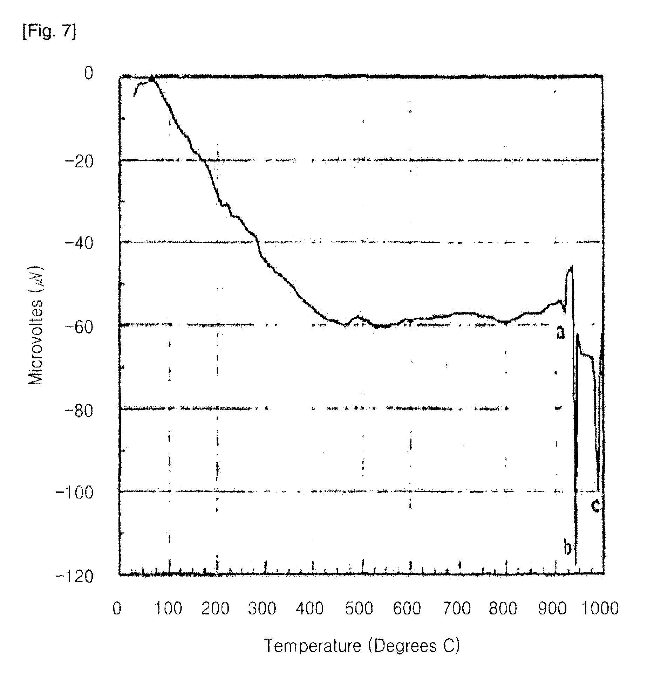

FIGS. 7 through 10 are graphs showing changes in the melting points of Y123-Ag and Ag as a function of oxygen partial pressure; and

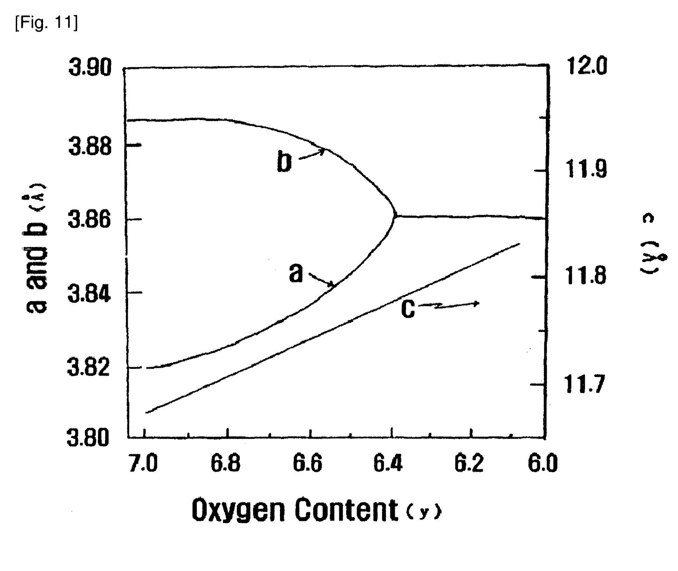

FIG. 11 is a graph showing changes in the lattice parameters of a superconducting wire (YBCO-CC) with varying oxygen contents.

### [Best Mode]

Preferred embodiments of the present invention will now be described in more detail. However, it will be understood by those skilled in the art that these embodiments do not serve to limit the scope of the invention but are set forth for illustrative purposes. In describing the present invention, the same reference numerals denote the same parts throughout the drawings so as to avoid repeated explanation of the same parts.

FIG. 3 is a flow chart for explaining a method for joining second-generation high-temperature superconducting wires by melting diffusion under a controlled oxygen partial pressure according to an embodiment of the present invention.

FIG. 4 is a view illustrating one of the second-generation high-5 temperature superconducting wires (YBCO-CC) after a portion of a stabilizer layer is removed from one end of the superconducting wire, in accordance with the embodiment of the present invention. Each of the second-generation high-temperature superconducting wires 20 includes a substrate 21, a buffer layer 22, a superconducting layer 23 and a stabilizer layer 24.

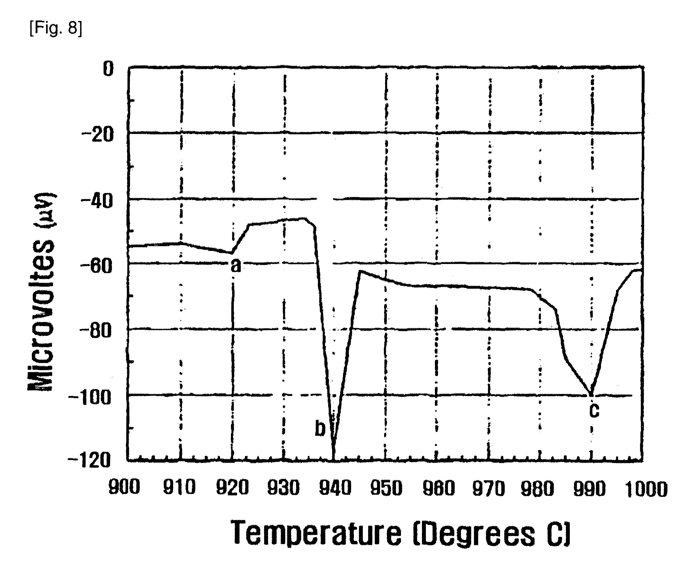

Referring to FIG. 3, the method according to an embodiment of the present invention comprises etching one end of each of the two strands of superconducting wire 20 to partially remove the stabilizer layers 24 and to expose portions of the superconducting layers 23 (S10), bringing the exposed superconducting layers 23 into contact with each other and fixing the exposed superconducting layers 23 to each other by a holder (S20), heating the fixed portions to the melting point of the superconducting layers in a furnace under a controlled oxygen partial pressure to join the fixed portions together by melting diffusion (S30), and oxidizing the junction between the superconducting wires in an oxygen atmosphere ('oxygenation annealing') (S40). Hereinafter, the individual steps of the method according to an embodiment of the present invention will be explained in detail with reference to FIG8. 4 through 6.

In step S 10, a predetermined length from one end of each of the two strands of superconducting wire 20 is etched to remove a portion of the stabilizer layer 24. Preferably, step S10 includes (a1) applying a resist onto a region ranging from one end of each of the strands of superconducting wire 20 to a portion 25 spaced a predetermined distance from the end of the superconducting wire 20, and (a2) removing a portion of the stabilizer layer 24 ranging from the other distal end of the superconducting wire 20 to the portion 25 spaced a predetermined distance from the distal end of the superconducting wire 20 by etching. Each of the superconducting layers 23 is formed of a superconductor through which a persistent current can flow. The superconducting layer 23 is formed between the buffer layer 22 and the stabilizer layer 24 as normal conducting layers. This structure makes it impossible to join the superconductors together before etching.

In order to join the superconductors together, each of the stabilizer layers 24 covering the superconducting layers 23 should be partially removed to expose a portion of the superconducting layer 23. Preferably, the partial removal of the stabilizer layers 24 is achieved by an optical or chemical process. FIG. 4 illustrates a state in which one of the stabilizer layers 24 to be joined together is partially removed to expose a portion of the superconducting layer 23.

Etching may be performed as the chemical process to partially remove the stabilizer layers 24 in accordance with the following procedure. First, a resist is applied onto a region other than a portion of each of the stabilizer layers 24 to 20 be removed. The superconducting wires 20 are joined together in a region ranging from one distal end of each of the superconducting wires to the portion 25 spaced a predetermined distance from the distal end. Therefore, the resist is applied onto a region of the stabilizer layer 24 other than the region where the superconducting wires are to be joined together. That is, the resist is applied from the portion 25 toward the other distal end of the superconducting wire 20.

Then, an etchant is used to etch the stabilizer layer 24. The etchant is a chemical capable of etching the material for the stabilizer layer 24. The etchant is properly selected depending on the kind of the material for the stabilizer layer 24. The etching is performed by any suitable process known in the art, and thus a detailed explanation thereof is omitted. One or more embodiments of the present invention is not limited to etching as a process for the partial removal of the stabilizer layer 24 of the superconducting wire. That is, the stabilizer layer 24 can be partially removed by any other suitable process.

Fig. 5 is a view illustrating a state in which the two strands of superconducting wire face and are brought into contact with each other in accordance with an embodiment of the present invention. FIG. 6 is a view illustrating the constitution of a holder for holding the two strands of superconducting wire in contact with each other in accordance with an embodiment of the present invention. Hereinafter, step S20 will be explained in more detail with reference to FIGS. 3 through 6.

In step 20, the ends of the two strands of superconducting wire 20 overlap each other and are hold by a holder 30 in a state in which the exposed portions of the superconducting layers 23 are brought into contact with each other. Preferably, the holder 30 holds the stands of superconducting wire 20 in a state in which the distal end of one of the stands of superconducting wire 20 is in touch with the stepped portion 25 of the other strand of superconducting wire to allow the superconducting layers 23 to be in close contact with each other.

Preferably, the holder 30 includes upper and lower metal plates 31 and fastening means for fastening the metal plates 31. In step S20, the metal plates 31 are arranged to face each other through the two strands of superconducting wire 20, which are in contact with each other, and are fastened to each other by the fastening means. It is particularly preferred that the holder 30 be made of a material resistant to a temperature of at least 1,000 °C. Specifically, the two superconducting wires 20, from which the stabilizer layers 24 are partially removed, are arranged to overlap each other, as illustrated in FIG. 5. The superconducting wires 20 are located in such a manner that one distal end of one strand of superconducting wire 20 is in touch with the stepped portion 25 of the other strand of superconducting wire 20. The removal of the same lengths of the stabilizer layers 24 from the two superconducting wires 20 allows for the exposed portions of the superconducting layers 23 to be in tight contact with each other.

Next, as illustrated in FIG. 6, the superconducting layers 23 of the superconducting wires 20, from which the stabilizer layers 24 are partially removed by etching, are positioned to face each other, and the superconducting wires 20 are held by the holder 30. The holder 30 comprises the two facing metal plates 31, bolts 33 and nuts 34 as the fastening means, and fastening holes 32 through which the fastening means are connected to the metal plates 31. The metal plates 31 are fastened to each other by the bolts 33 and the nuts 34 through the fastening holes 32 to hold the superconducting wires 20 in contact with each other.

The holder 30 should be made of a material that is sufficiently heat resistant to withstand the subsequent high-temperature heat treatment. It is particularly preferred that the constituent elements of the holder 30 be heat- resistant sufficiently to withstand a temperature of at least 1,000 °C because the subsequent melting diffusion occurs at a temperature of 800°C or above.

This joining prevents the generation of Joule's heat due to the occurrence of contact resistance and protects the superconducting layers 23 from quenching because any normal conducting layer does not exist between the superconducting layers 23.

In step S30, the fixed portions of the superconducting layers 23 are heated to the melting point of the superconducting layers 23 in a furnace at an oxygen partial pressure of zero ('vacuum') to melt-diffuse the superconducting layers 23 in contact with each other. The vacuum also includes a state close to the vacuum. The vacuum state is preferably set to a pressure of about 10 Pa or below. That is, the fixed two strands of superconducting wire 20 are put into a furnace, where bonding between the superconducting layers 23 is induced by melting diffusion.

Taking into advantage of changes in the melting point of the superconductors as a function of oxygen partial pressure, the temperature of the furnace can be controlled to induce bonding between the superconducting layers 23 by melting diffusion. That is, the reason for the heating temperature control for melting diffusion is to protect the portions (or the layers) of the superconducting wires other than the superconducting layers 23 from deformation or contamination by the heating.

For example, YBCO, a superconductor material of a second-generation high-temperature superconducting wire, begins to melt at around 980°C in ambient air (Po₂ of 21.3 kPa). That is, the melting point of YBCO is about 980 °C. Accordingly, when YBCO is used as the superconductor for the superconducting wires 20, a heating temperature of around 980°C is required to join the fixed portions 26 of the superconducting wires 20 by melting diffusion.

Silver (Ag), which is typically used as a material for the stabilizer layers 24, has a eutectic melting point of 935°C to 940 °C in ambient air (Po₂ of 21.3 kPa). When the portions 26 of the superconducting wires are joined together by melting diffusion around 980 °C, the silver (Ag) is more rapidly melted than the portions 26. The melting of the silver (Ag) before the bonding between the superconducting layers 23 during the heat treatment of the superconducting wires causes many problems.

Thus, there is a need to melt-diffuse the superconducting layers 23 without melting the silver (Ag) present in the stabilizer layers 24.

This need can be met by using the phenomenon that the Y123-Ag is melted at a temperature lower than the eutectic melting point of the Ag at an oxygen partial pressure close to a vacuum. That is, heat treatment of the superconducting layers under vacuum at the melting point of the Y123-Ag can induce bonding between the superconducting layers 23 by diffusion or melting of the Y123-Ag. At this time, the Ag is not melted because the heat-treatment temperature (or the melting point of the Y123-Ag) is lower than the eutectic melting point of the Ag.

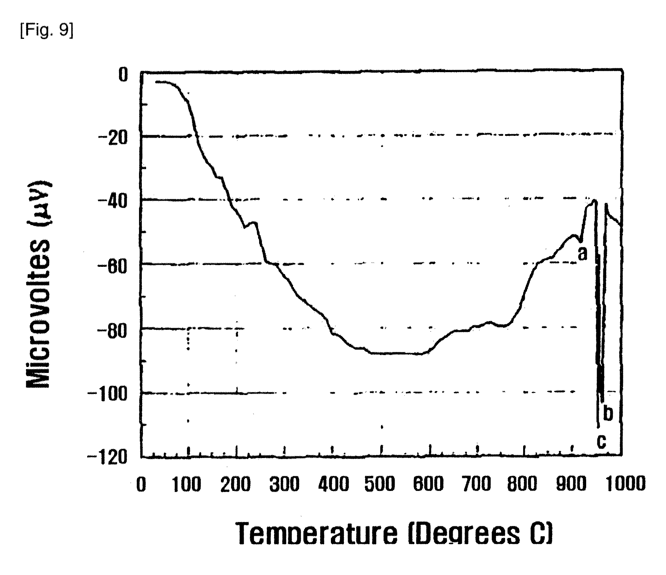

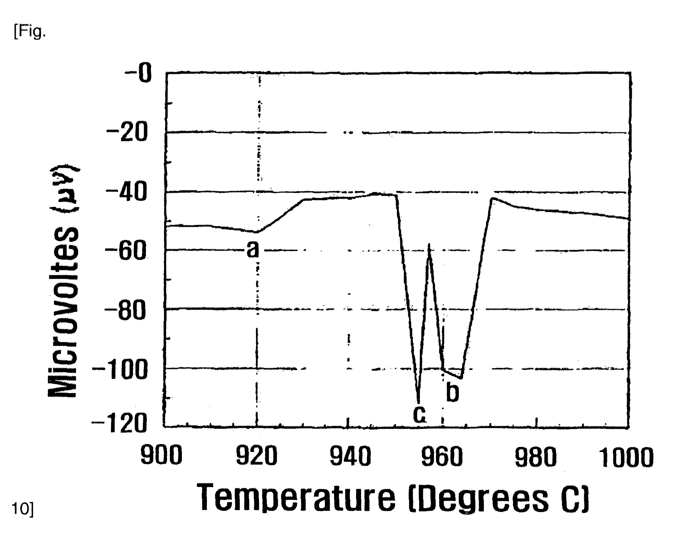

Referring to FIGS. 7 through 10, the melting point curves of the Y123-Ag and the Ag cross each other with increasing oxygen partial pressure. FIGS. 7 and 8 are graphs showing changes in the melting points of the Y123-Ag and the Ag in ambient air. FIGS. 9 and 10 are graphs showing changes in the melting points of the Y123-Ag and the Ag at a low oxygen partial pressure. FIGS. 8 and 10 are enlargements of FIGS. 7 and 9 in the temperature range of 900 °C to 1,000 °C, respectively.

As shown in FIGS. 7 and 8, the eutectic melting point of the silver (Ag) in ambient air is from 935°C to 940°C (corresponding to peak 'b' in FIG. 8) and that of the Y123-Ag in ambient air is 990°C (corresponding to peak 'c' in FIG. 8). That is, the melting point of the Y123-Ag is higher than that of the Ag.

Referring to FIGS. 9 and 10, the eutectic melting point of the silver (Ag) at an oxygen partial pressure of 0.55 kPa is 960°C (corresponding to peak 'b' in FIG. 10) and that of the Y123-Ag at an oxygen partial pressure of 0.55 kPa is from 950°C to 955°C (corresponding to peak 'c' in FIG. 10). That is, the melting point of the Y123-Ag is lower than that of the Ag.

The eutectic melting points and melting points of the Ag and the Y123-Ag are summarized in Table 1.

**TABLE 1**

| | | In ambient air | In vacuum state |
|---|---|---|---|
| Y123-Ag | 980°C | 950-955°C | |
| Ag | 935-940oC | 960°C | |

The results in Table 1 are experimental values. The measured temperatures may be slightly varied depending on the state of the Y123-Ag, i.e. the Ag content. Further, the experimental results may also be slightly varied depending on the state of the Ag or the experimental conditions.

The above principle can be applied to the method according to embodiments of the present invention although there is a slight difference in temperature depending on the type (for example, bulk or thin film type) of the superconductor or the state of the Ag. This temperature difference is also included in embodiments of the present invention. The method according to embodiments of the present invention takes advantage of the phenomenon that the melting points (or the eutectic melting points) of the Y123-Ag and the Ag are reversed depending on the oxygen partial pressure. In other words, heat treatment at a low oxygen partial pressure can induce bonding between the superconducting layers without any problems arising from the melting of the Ag.

In step S40, the junction between the superconducting layers is oxidized in an oxygen atmosphere at 450°C to 550°C ('oxygenation annealing'). It is preferred to perform the oxygenation annealing by continuously circulating a flow of oxygen in the furnace. Particularly, in step S40, the oxygenation annealing is performed by inducing in-diffusion of the ambient oxygen atoms into the superconducting layers until the content of oxygen (O) atoms in the superconducting layers becomes 6.4 to 7 moles on the basis that yttrium (Y), barium (Ba) and copper (Cu) as the constituent elements of the superconducting layers are 1, 2 and 3 moles, respectively.

The superconducting layers 23 are formed of an oxide superconducting material, typified by YBa₂Cu₃O₇₋ₓ in which the molar ratio of Y:Ba:Cu is 1:2:3 and the molar ratio (7-x) of oxygen (O) is typically in the range of 6.4 to 7.

When the heat treatment temperature is maintained at a high temperature of at least 900°C in step S30, oxygen (O) escapes from YBa₂Cu₃O₇₋ₓ, constituting the superconducting layers 23, and as a result, the molar ratio (7-x) of oxygen (O) is reduced to below 6.4.

This oxygen content reduction results in a phase transition of the superconducting layers 23 from a superconducting orthorhombic phase to a non-superconducting tetragonal phase. That is, the superconducting layers 23 lose their superconducting properties.

The phase transition of the superconducting layers 23 will be explained in more detail with reference to FIG. 11. As shown in FIG. 11, the lattice parameters of the superconducting material YBa2Cu307-X are varied depending on the oxygen content. In FIG. 11, the x-axis shows the oxygen content and the y-axis shows the lattice parameters. Particularly, the oxygen content of the x axis indicates *7-x* in YBa₂Cu₃O₇₋ₓ.

In FIG. 11, the lattice parameters a and b are equal to each other at an oxygen content lower than 6.4, indicating that the superconducting layers 23 have a tetragonal phase and lose their superconducting properties. To sum up, the high-temperature heat treatment of the superconducting layers 23 in a vacuum state to change the melting points of the Y-123 and the Ag leads to loss of oxygen, and as a result, the superconducting layers 23 undergo a phase transition and lose their superconducting properties. In view of these problems, in step S40, the superconducting layers 23 are oxidized in an oxygen atmosphere at about 450°C. to about 650 °C. ('oxygenation annealing'). This oxygenation annealing compensates for the oxygen loss from the superconducting layers 23 to restore the superconducting properties of the superconducting layers 23.

The oxygen atmosphere is created by continuously circulating a flow of oxygen in the furnace, where the oxygenation annealing is performed. Particularly, the reason for the limitation of the oxygenation annealing temperature is that the orthorhombic phase of the superconducting layers 23 is most stabilized in the temperature range of 450°C to 650 °C.

The oxygenation annealing time in step 40 should be controlled. If the oxygenation annealing is performed in an oxygen atmosphere for too long a time, the oxygen content of the superconducting layers 23 is increased. Meanwhile, if the oxygenation annealing is not performed for a sufficient time, the oxygen content of the superconducting layers 23 is low, resulting in loss of superconducting properties.

Although the foregoing embodiments describe that the superconducting layers 23 are composed of YBa₂Cu₃O₇₋ₓ as an oxide superconducting material and the stabilizer layers 24 are formed on top of the superconducting layers 23, the present invention is not limited to the embodiments. That is, so long as the normal conducting layers can be partially removed irrespective of the kinds of the substrates and the stabilizer layers of the superconducting wires, the superconducting layers can be joined together in a simple manner by heat treatment. In addition, the superconducting layers can be joined in a simple manner by heat treatment after the removal of the normal conducting layers, and in actuality, the method according to embodiments of the present invention can be conveniently used in the construction of a superconducting system.

Although embodiments of the present invention has been described herein with reference to the preferred embodiments, those skilled in the art will appreciate that various modifications are possible, without departing from the spirit of the present invention. Therefore, the embodiments serve to illustrate the nature of the invention and they should not be considered in the limiting sense thereof. Thus, the scope of the present invention should be defined by the appended claims, and all changes which come within the meaning and range of equivalency of the claims should be construed as falling within the scope of the invention.

### [Industrial Applicability]

As described above, the method according to embodiments of the present invention can be used to join the two strands of second-generation high-temperature superconducting wire together. In addition, the method according to embodiments of the present invention can be used to fabricate sufficiently long superconducting wires for use in the development of all superconducting magnet systems, and particularly, it can be applied to the construction of applied systems, such as MRI, NMR and SMES magnet systems, which are essentially operated in a persistent current mode.

## Claims

1. A method for joining two strands of second-generation high temperature superconducting wire, each of which comprises a superconducting layer and a stabilizer layer, the method comprising
(a) partially removing each of the stabilizer layers to expose a portion of the superconducting layer,
(b) bringing the exposed portions of the superconducting layers into contact with each other and fixing the superconducting layers to each other,
(c) heating the fixed portions of the superconducting layers to the melting point of the superconducting layers to melt-diffuse the superconducting layers in contact with each other and to join the strands of superconducting wire together, and
(d) oxidizing the junction between the strands of superconducting wire in an oxygen atmosphere ('oxygenation annealing').

2. The method of claim 1, wherein in step (c), the strands of superconducting wire are joined together under a controlled oxygen partial pressure where the melting point of the superconducting layers becomes lower than the melting point of the stabilizer layers.

3. The method of claim 1, wherein step (a) includes (a1) patterning each of the stabilizer layers using a resist to expose a portion of the stabilizer layer and (a2) removing the exposed portions of the stabilizer layers by etching.

4. The method of claim 1, wherein in step (a), a region ranging from one distal end of each of the superconducting wires to a portion spaced a predetermined distance from the distal end of the superconducting wire is removed from the stabilizer layer, and wherein in step (b), one distal end of one of the strands of superconducting wire is in touch with a stepped portion of the other strand of superconducting wire and the superconducting layers are fixed in close contact with each other.

5. The method of claim 4, wherein in step (b), after the superconducting layers of the two strands of superconducting wire are brought into contact with each other, upper and lower metal plates and fastening means for fastening the metal plates are used to fix the superconducting layers to each other.

6. The method of claim 5, wherein the metal plates and the fastening means are made of a material resistant to a temperature of at least 1,000 °C.

7. The method of claim 1, wherein step (d) is carried out by continuously circulating a flow of oxygen in a furnace at 450°C to 650°C.

8. The method of claim 1, wherein step (d) is carried out until the content of oxygen (0) atoms in the superconducting layers becomes 6.4 to 7 moles on the basis that yttrium (Y), barium (Ba) and copper (Cu) as constituent elements of the superconducting layers are 1, 2 and 3 moles, respectively.
